# EUROPEAN PATENT APPLICATION

(11) **EP 4 280 249 A1**
(43) Date of publication of application: **22.11.2023**
(21) Application number: 23172288.5
(22) Date of filing: 09.05.2023
(51) Int. Cl.: H01H 71/02, H05K 5/02

(54) **CIRCUIT BREAKER HOUSING WITH TWO-STAGE STRUCTURE**

(30) Priority: 20.05.2022 US 202217749458; 27.09.2022 US 202217953904
(71) Applicant: Rockwell Automation Technologies, Inc., Mayfield Heights OH 44124 (US)
(72) Inventor: Brugger, Daniel, Mayfield Heights (US); von Arx, Rahel, Mayfield Heights (US); Villiger, Beat, Mayfield Heights (US); Pimple, Sadashiv Devidasrao, Mayfield Heights (US); Kaltenrieder, Reynald, Mayfield Heights (US); Zahner, Philipp A., Mayfield Heights (US); Barandun, Gion Andrea, Mayfield Heights (US)
(74) Representative: Grünecker Patent- und Rechtsanwälte PartG mbB

(57) **Abstract**

A component that includes a housing for a circuit breaker and a reinforcement element mounted on the housing is disclosed. The housing includes outer walls on at least four sides. The reinforcement element is mounted on the housing along a reinforced side of the housing. The reinforced side is a side of the four sides. The reinforcement element is formed separately than the housing. The reinforcement element is placed external to the reinforced side of the housing, subject to deformation outward from an interior of the housing during a short circuit event.

## Description

### CROSS-REFERENCE TO RELATED APPLICATIONS

This is a continuation-in-part application of and claims priority to United States Nonprovisional Patent Application Number 17/749,458 entitled "CIRCUIT BREAKER HOUSING FORMED USING INJECTION MOLDING WITH A REINFORCEMENT MATERIAL ON AN OUTER SURFACE" and filed on May 20, 2022 for Daniel Brugger, which is incorporated herein by reference.

### BACKGROUND INFORMATION

The subject matter disclosed herein relates to circuit breaker housings and more specifically to circuit breaker housings with two-stage structures.

### BRIEF DESCRIPTION

A component for circuit breaker housings with a two-stage structure is disclosed herein. The component includes a housing for a circuit breaker. The housing includes outer walls on at least four sides. The component includes a reinforcement element mounted on the housing along a reinforced side of the housing. The reinforced side includes a side of the four sides. The reinforcement element is formed separately than the housing. The reinforcement element is placed external to the reinforced side of the housing subject to deformation outward from an interior of the housing during a short circuit event.

A method is disclosed herein. The method includes providing a housing for a circuit breaker. The housing includes outer walls on at least four sides. The method includes connecting a reinforcement element to the housing along a reinforced side of the housing. The reinforced side includes a side of the four sides. The reinforcement element is formed separately than the housing. The reinforcement element is placed external to the reinforced side of the housing subject to deformation outward from an interior of the housing during a short circuit event.

A component for circuit breaker housings with a two-staged structure is disclosed herein. The component includes a housing for a circuit breaker. The housing includes outer walls on at least four sides, a top side that is open, and a bottom side that is closed. The component includes a reinforcement element mounted on each of two reinforced sides. The reinforced sides include two of the four sides that are opposite each other. The reinforcement elements are mounted along a top portion adjacent to the top side of the housing. The reinforcement elements are formed separately than the housing. The reinforcement elements are placed external to the reinforced side of the housing subject to deformation outward from an interior of the housing during a short circuit event.

### BRIEF DESCRIPTION OF THE DRAWINGS

In order that the advantages of the embodiments of the invention will be readily understood, a more particular description of the embodiments briefly described above will be rendered by reference to specific embodiments that are illustrated in the appended drawings. Understanding that these drawings depict only some embodiments and are not therefore to be considered to be limiting of scope, the embodiments will be described and explained with additional specificity and detail through the use of the accompanying drawings, in which:
Figure 1 is a diagram of a circuit breaker housing, according to various embodiments;
Figure 2 is a diagram of a circuit breaker housing with reinforcement material on one side, according to various embodiments;
Figure 3 is a diagram of a circuit breaker housing with reinforcement material around the circuit breaker housing, according to various embodiments;
Figure 4 is a diagram of a circuit breaker housing with reinforcement material in U-shaped strips, according to various embodiments;
Figure 5 is a diagram of a circuit breaker housing with reinforcement material in a band around a top portion and U-shaped strips, according to various embodiments;
Figure 6 is a diagram of an isolated view of the reinforcement material of the circuit breaker housing of Figure 5, according to various embodiments;
Figure 7 is a schematic block diagram illustrating a process for creating a portion of a circuit breaker housing with heated reinforcement material, according to various embodiments;
Figure 8 is a diagram illustrating a process for creating a portion of a circuit breaker housing by placing reinforcement material in a mold and holding the reinforcement material in place with a vacuum before an injection process, according to various embodiments;
Figure 9 is a diagram illustrating a mold for placement of a reinforcement material in position held by pins, according to various embodiments;
Figure 10 is a diagram illustrating a cross section of a reinforcement material bonded to an injected wall material, according to various embodiments;
Figure 11 is a schematic flowchart diagram illustrating a method for creating a circuit breaker housing using an injected wall material with a reinforcement material along an outer surface, according to various embodiments;
Figure 12 is a schematic flowchart diagram illustrating a method for creating a circuit breaker housing using an injected wall material with a reinforcement material along an outer surface where the reinforcement material is heated and pressed into shape, according to various embodiments;
Figure 13 is a schematic flowchart diagram illustrating a method for creating a circuit breaker housing using an injected wall material with a reinforcement material along an outer surface where the reinforcement material is positioned in a mold and pinned in position, according to various embodiments;
Figure 14 is a diagram of a circuit breaker housing with reinforcement elements extending along reinforced sides of the housing and partially along sides adjacent to the reinforced sides in a recess in the housing, according to various embodiments;
Figure 15 is a diagram of a circuit breaker housing with a reinforcement element around the circuit breaker housing in a recess in the housing, according to various embodiments;
Figure 16 is a diagram of a circuit breaker housing with reinforcement elements along portions of two sides of the circuit breaker housing with a gap in the reinforcement element, according to various embodiments;
Figure 17 is a diagram of a circuit breaker housing with reinforcement elements recessed into two sides, according to various embodiments;
Figure 18 is a diagram of a circuit breaker housing with reinforcement elements along portions of two sides recessed into the housing, according to various embodiments;
Figure 19 is an isolated section view of an attachment point of a reinforcement element of Figure 14 with a protrusion from the circuit breaker housing and corresponding recess in the reinforcement element, according to various embodiments;
Figure 20 is an isolated section view of an attachment point of a reinforcement element of Figure 14 with a hook-shaped protrusion from the circuit breaker housing and corresponding shape on the reinforcement element, according to various embodiments;
Figure 21 is an isolated section view of an attachment point of a reinforcement element of Figure 14 with a recess in the circuit breaker housing and corresponding pointed shape for the reinforcement element, according to various embodiments;
Figure 22 is an isolated section view of an attachment point of a reinforcement element with a recess in the circuit breaker housing and corresponding protrusion on the reinforcement element, according to various embodiments;
Figure 23 is an isolated section view of an attachment point of a reinforcement element similar to the embodiments of Figure 16 that is attached with rivets, according to various embodiments;
Figure 24 is an isolated view of an attachment point of a reinforcement element similar to the embodiments of Figure 14 where the reinforcement element 2401 is attached to the housing using welds and/or an adhesive, according to various embodiments; and
Figure 25 is a diagram illustrating a portion of a circuit breaker housing with a reinforced side and a section view of a reinforcement element with a gap during a) a normal condition, and b) during short circuit event, according to various embodiments.

### DETAILED DESCRIPTION

Reference throughout this specification to "one embodiment," "an embodiment," or similar language means that a particular feature, structure, or characteristic described in connection with the embodiment is included in at least one embodiment. Thus, appearances of the phrases "in one embodiment," "in an embodiment," and similar language throughout this specification may, but do not necessarily, all refer to the same embodiment, but mean "one or more but not all embodiments" unless expressly specified otherwise. The terms "including," "comprising," "having," and variations thereof mean "including but not limited to" unless expressly specified otherwise. An enumerated listing of items does not imply that any or all of the items are mutually exclusive and/or mutually inclusive, unless expressly specified otherwise. The terms "a," "an," and "the" also refer to "one or more" unless expressly specified otherwise. The term "and/or" indicates embodiments of one or more of the listed elements, with "A and/or B" indicating embodiments of element A alone, element B alone, or elements A and B taken together.

Furthermore, the described features, advantages, and characteristics of the embodiments may be combined in any suitable manner. One skilled in the relevant art will recognize that the embodiments may be practiced without one or more of the specific features or advantages of a particular embodiment. In other instances, additional features and advantages may be recognized in certain embodiments that may not be present in all embodiments.

These features and advantages of the embodiments will become more fully apparent from the following description and appended claims or may be learned by the practice of embodiments as set forth hereinafter. As will be appreciated by one skilled in the art, aspects of the present invention may be embodied as a system, method, and/or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module," or "system." Furthermore, aspects of the present invention may take the form of a computer program product embodied in one or more computer readable medium(s) having program code embodied thereon.

The computer readable medium may be a tangible computer readable storage medium storing the program code. The computer readable storage medium may be, for example, but not limited to, an electronic, magnetic, optical, electromagnetic, infrared, holographic, micromechanical, or semiconductor system, apparatus, or device, or any suitable combination of the foregoing.

More specific examples of the computer readable storage medium may include but are not limited to a portable computer diskette, a hard disk, a random access memory (RAM), a read-only memory (ROM), an erasable programmable read-only memory (EPROM or Flash memory), a portable compact disc read-only memory (CD-ROM), a digital versatile disc (DVD), an optical storage device, a magnetic storage device, a holographic storage medium, a micromechanical storage device, or any suitable combination of the foregoing. In the context of this document, a computer readable storage medium may be any tangible medium that can contain, and/or store program code for use by and/or in connection with an instruction execution system, apparatus, or device.

Program code for carrying out operations for aspects of the present invention may be written in any combination of one or more programming languages, including an object-oriented programming language such as Python, Ruby, R, Java, Java Script, Smalltalk, C++, C sharp, Lisp, Clojure, PHP or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). The computer program product may be shared, simultaneously serving multiple customers in a flexible, automated fashion.

The schematic flowchart diagrams and/or schematic block diagrams in the Figures illustrate the architecture, functionality, and operation of possible implementations. It should also be noted that, in some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. Although various arrow types and line types may be employed in the flowchart and/or block diagrams, they are understood not to limit the scope of the corresponding embodiments. Indeed, some arrows or other connectors may be used to indicate only an exemplary logical flow of the depicted embodiment.

The description of elements in each figure may refer to elements of proceeding figures. Like numbers refer to like elements in all figures, including alternate embodiments of like elements.

As used herein, a list with a conjunction of "and/or" includes any single item in the list or a combination of items in the list. For example, a list of A, B and/or C includes only A, only B, only C, a combination of A and B, a combination of B and C, a combination of A and C or a combination of A, B and C. As used herein, a list using the terminology "one or more of' includes any single item in the list or a combination of items in the list. For example, one or more of A, B and C includes only A, only B, only C, a combination of A and B, a combination of B and C, a combination of A and C or a combination of A, B and C.

A component that includes a circuit breaker housing with a reinforcement material impregnated in an outer surface is disclosed. The component includes a circuit breaker housing with outer walls on at least four sides where the circuit breaker housing is formed by injection of a heated wall material into a housing mold. The component includes a reinforcement material impregnated in an outer surface of one or more of the at least four sides. The reinforcement material is bonded to the circuit breaker housing during injection of the heated wall material.

In some embodiments, fibers of the reinforcement material are positioned in the one or more of the at least four sides in a direction to fortify the circuit breaker housing to resist pressures caused in a short circuit condition. In other embodiments, the reinforcement material includes unidirectional fibers. In other embodiments, the reinforcement material includes two or more layers where each layer of the two or more layers includes fibers running in a different direction than fibers of another layer of the two or more layers.

In some embodiments, a portion of the reinforcement material wraps around two or more adjacent sides of the circuit breaker housing. In other embodiments, the portion of the reinforcement material wraps in a loop around four adjacent sides of the circuit breaker housing. In other embodiments, the portion of the reinforcement material that wraps in a loop around the four adjacent sides of the circuit breaker housing includes a strip less than a width of each of the four adjacent sides where the width is measured in a direction perpendicular to the loop of reinforcement material and the circuit breaker housing includes one or more strips of the reinforcement material running in a direction perpendicular to the loop of reinforcement material.

In some embodiments, the wall material includes a thermoplastic resin. In other embodiments, the reinforcement material is impregnated with a bonding material capable of bonding to the heated wall material when heated. In other embodiments, the reinforcement material is the same as the wall material. In other embodiments, the component includes a circuit breaker within the circuit breaker housing and/or and a faceplate attached to a side of the circuit breaker housing.

A method for forming a circuit breaker housing with a reinforcement material in an outer surface includes positioning a reinforcement material in a housing mold for a circuit breaker housing. The circuit breaker housing includes outer walls on at least four sides and the reinforcement material is positioned to be on an outer surface of one or more of the at least four sides. The method includes injecting a heated wall material, using an injection molding process, in a portion of the housing mold interior to the reinforcement material to form the circuit breaker housing. The heated wall material bonds to the reinforcement material as the heated wall material is injected in the housing mold and the reinforcement material is in the outer surface of the one or more of the at least four sides of the circuit breaker housing.

In some embodiments, the reinforcement material is impregnated with a bonding material capable of bonding to the heated wall material when heated. In other embodiments, the method includes, prior to positioning the reinforcement material in the housing mold, heating the reinforcement material such that the bonding material is in a pliable state and pressing the reinforcement material into a shape matching a shape of an outer surface of the circuit breaker housing. In other embodiments, the method includes, after positioning the reinforcement material in the housing mold and prior to injecting the heated wall material, restraining the reinforcement material in a position where the reinforcement material was positioned in the housing mold.

In some embodiments, positioning the reinforcement material in the housing mold includes positioning fibers of the reinforcement material in the housing mold in a location and direction to fortify the circuit breaker housing to resist pressures caused in a short circuit condition. In other embodiments, the reinforcement material includes two or more layers where each layer of the two or more layers includes fibers running in a different direction than fibers of another layer of the two or more layers. In other embodiments, the reinforcement material is impregnated with a bonding material capable of bonding to the heated wall material when heated.

Another method for forming a circuit breaker housing with a reinforcement material in an outer surface includes heating a reinforcement material impregnated with a bonding material where the bonding material is heated to a pliable state, placing the heated reinforcement material into a reinforcement mold, and pressing the reinforcement material in the reinforcement mold into a shape matching a shape of an outer surface of a circuit breaker housing. The circuit breaker housing includes outer walls on at least four sides and the reinforcement material is positioned to be on an outer surface of one or more of the at least four sides. The method includes positioning the reinforcement material in a housing mold for the circuit breaker housing, injecting a heated wall material, using an injection molding process, in a portion of the housing mold interior to the reinforcement material to form the circuit breaker housing, and removing the circuit breaker housing from the housing mold. The bonding material of the reinforcement material is heated to a temperature such that the heated wall material bonds to the reinforcement material as the heated wall material is injected in the housing mold, and the reinforcement material is in the outer walls of the at least four sides of the circuit breaker housing.

In some embodiments, positioning the reinforcement material in the housing mold includes positioning fibers of the reinforcement material in the housing mold in a location and direction to fortify the circuit breaker housing to resist pressures caused in a short circuit condition.

A component that includes a housing for a circuit breaker is disclosed. The housing includes outer walls on at least four sides. The component includes a reinforcement element mounted on the housing along a reinforced side of the housing. The reinforced side includes a side of the four sides. The reinforcement element is formed separately than the housing. The reinforcement element is placed external to the reinforced side of the housing subject to deformation outward from an interior of the housing during a short circuit event.

In some embodiments, the housing includes a top side that is open and a bottom side that is closed. The reinforcement element is located on the reinforced side of the housing along a top portion adjacent to the top side of the housing. In some embodiments, the reinforcement element covers the reinforced side of the housing. In some embodiments, the reinforcement element includes a portion at each end of the reinforced side that wraps around and covers a portion of two sides adjacent to the reinforced side. The reinforcement element attaches to the housing on the two sides adjacent to the reinforced side. In some embodiments, the reinforcement element fits in a recess in the housing.

In some embodiments, the reinforcement element and housing are configured so the reinforcement element snaps into place on the housing. In some embodiments, the reinforcement element snaps into place on the housing with (i) a protrusion at an end of the reinforcement element and a corresponding opening on the housing and/or (ii) a protrusion on the housing and a corresponding opening at the end of the reinforcement element. In some embodiments, the reinforcement element connects to the housing via a weld, a connector, and/or an adhesive at least at each end of the reinforcement element.

In some embodiments, the housing includes a material and a design such that pressure formed during a short circuit event causes the reinforced side to expand past a desired point of expansion. The reinforcement element is positioned against the housing and includes a material and a design to limit expansion of the reinforced side to the desired point of expansion.

In some embodiments, the housing includes a material and a design such that pressure formed during a short circuit event causes the reinforced side to expand past a desired point of expansion. The reinforcement element includes a gap between the reinforced side and the reinforcement element. During a short circuit event, the reinforced side expands to the reinforcement element and to the desired point of expansion.

In some embodiments, the reinforcement element includes a plastic, fibers, and/or a tape. In some embodiments, the housing includes two or more reinforced sides, each with a reinforcement element. In some embodiments, the reinforcement element wraps around the four sides of the housing.

A method including providing a housing for a circuit breaker is disclosed herein. The housing includes outer walls on at least four sides. The method includes connecting a reinforcement element to the housing along a reinforced side of the housing. The reinforced side includes a side of the four sides. The reinforcement element is formed separately than the housing. The reinforcement element is placed external to the reinforced side of the housing subject to deformation outward from an interior of the housing during a short circuit event.

In some embodiments, the housing includes a top side that is open and a bottom side that is closed. The reinforcement element is located on the reinforced side of the housing along a top portion adjacent to the top side of the housing. In some embodiments, the reinforcement element fits in a recess in the housing.

In some embodiments, the reinforcement element includes a portion at each end of the reinforced side that wraps around and covers a portion of two sides adjacent to the reinforced side. The reinforcement element attaches to the housing on the two sides adjacent to the reinforced side.

In some embodiments, the reinforcement element and housing are configured so the reinforcement element snaps into place on the housing. The reinforcement element snaps into place on the housing with (i) a protrusion at an end of the reinforcement element and a corresponding opening on the housing and/or (ii) a protrusion on the housing and a corresponding opening at the end of the reinforcement element.

In some embodiments, the housing includes a material and a design such that pressure formed during a short circuit event causes the reinforced side to expand past a desired point of expansion. In some embodiments, the reinforcement element is positioned against the housing and includes a material and a design to limit expansion of the reinforced side to the desired point of expansion. In some embodiments, the reinforcement element includes a gap between the reinforced side and the reinforcement element. During a short circuit event, the reinforced side expands to the reinforcement element and to the desired point of expansion.

Embodiments of the present disclosure include a component. The component includes a housing for a circuit breaker. The housing includes outer walls on at least four sides, a top side that is open, and a bottom side that is closed. The component includes a reinforcement element mounted on each of two reinforced sides. The reinforced sides include two of the four sides that are opposite each other. The reinforcement elements are mounted along a top portion adjacent to the top side of the housing. The reinforcement elements are formed separately than the housing. The reinforcement elements are placed external to the reinforced side of the housing subject to deformation outward from an interior of the housing during a short circuit event.

In some embodiments, the reinforcement element fits in a recess in the housing. In some embodiments, for each reinforcement element on a reinforced side, the reinforcement element includes a portion at each end of the reinforced side that wraps around and covers a portion of two sides adjacent to the reinforced side. The reinforcement element attaches to the housing on the two sides adjacent to the reinforced side. The reinforcement element and housing are configured so the reinforcement element snaps into place on the housing. The reinforcement element snaps into place on the housing with (i) a protrusion at an end of the reinforcement element and a corresponding opening on the housing and/or a protrusion on the housing and a corresponding opening at the end of the reinforcement element.

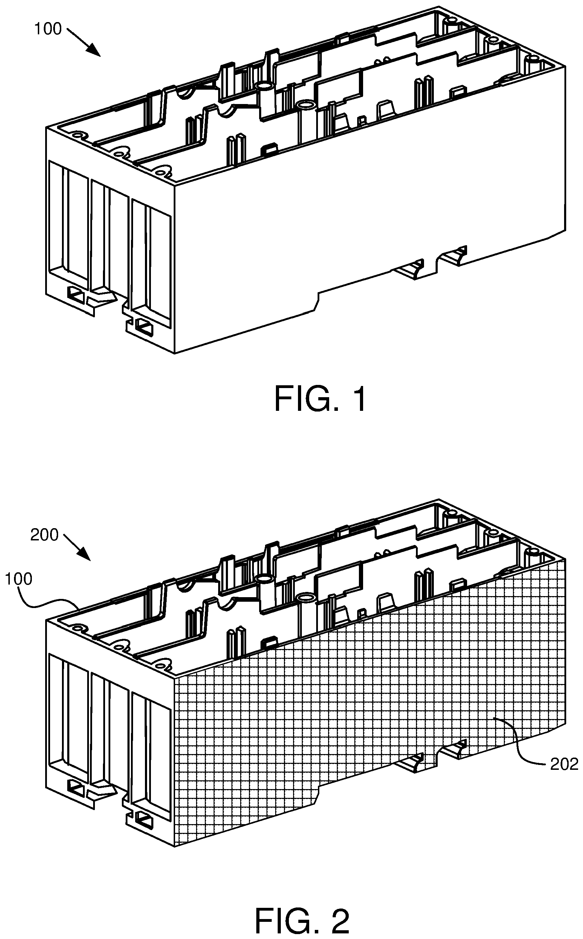

Figure 1 is a diagram of a circuit breaker housing 100, according to various embodiments. A circuit breaker housing is a structure that is shaped and designed to hold a circuit breaker. The circuit breaker housing 100 of Figure 1 is for a molded case circuit breaker ("MCCB"). A molded case circuit breaker is typically larger than a miniature circuit breaker ("MCB"), which are often found in electrical panels and often range from 1 ampere ("A") to 100 A. MCCBs typically range from 15 A to 2500 A. In some embodiments, the circuit breaker housing 100 is for a miniature circuit breaker.

Note that Figure 1 is for a particular circuit breaker that is representative of other circuit breakers and the embodiments described herein are applicable to various circuit breaker types. In addition, while the embodiments described herein include circuit breakers, the techniques described herein are also applicable to other electrical devices that interrupt electrical current, such as a disconnect switch, a fused disconnect, a manual motor controller, a combination motor controller, a molded case circuit breaker, a motor protection circuit breaker, a protection device within bucket in a motor control center, or other electrical device formed using injection molding and subject to the forces associated with opening contacts and short circuit conditions.

A circuit breaker is an electrical safety device designed to protect an electrical circuit from damage caused by a short circuit or overload. A circuit breaker is designed to open a set of contacts to interrupt current flow when current is above a rated ampacity. Typically, a circuit breaker has an inverse-time characteristic where currents just above the rated ampacity cause the circuit breaker to open after a relatively long period of time, such as minutes or hours, and high currents cause the circuit breaker to open quickly, in as little as a few milliseconds.

In a short circuit current situation where there is a short from line to ground, the short circuit current may be very high and is limited only by resistance of the short circuit and conductors. Short circuit currents are often in the tens of thousands of amps and maybe in the hundreds of thousands of amps. Opening the contacts of the circuit breaker in these conditions causes arcing across the contacts which results in high pressure within the circuit breaker housing.

Short circuit ratings are typically expressed in terms of amps interrupting capacity ("AIC") or short circuit current rating ("SCCR"). AIC describes the maximum fault current that a protective device can clear safely without welding closed contacts or causing damage to equipment or personnel. SCCR applies to complete pieces of equipment, such as motor control enclosures that include circuit breakers, fuses, contactors, etc. and describes the maximum fault current that the equipment can withstand safely or the maximum available fault current of the feeder to which the equipment can be safely connected. AIC is typically in the range of 5,000 to 200,000 amperes ("A") and SCCR is usually in the range of 18,000 to 200,000 A.

Where actual short circuit current exceeds the AIC or SCCR rating of a protective device, pressures caused by arcing current typically cause the protective device to explode, which can injure personnel, can cause a fire, or other catastrophic event. Thus, circuit breaker housings are designed to withstand high pressures caused by arcing currents of a short circuit condition up to the AIC and/or the SCCR rating. Typically, the outer walls of the circuit breaker housing bear the forces of the pressures from arcing current. Interior walls typically experience about the same pressures on both sides while outer walls experience a pressure force from the inside toward the outside of the circuit breaker housing. The outer walls of the circuit breaker housing are designed to withstand the forces caused by the pressure of arcing current in a short circuit condition. The outer walls may expand to some degree outwards during an arcing current event.

Circuit breakers are typically designed to have certain housing sizes to fit within motor control centers, distribution panels, motor starters, and the like. For a particular circuit breaker housing size, a particular circuit breaker type is often limited certain ampacity ratings. For example, an MCB may range from 1 A to 100 A. A certain 100 A frame size may have ampacities from 16 A to 100 A, while a larger 225 A frame size may have ampacities from 100 A to 225 A. A goal in design of a circuit breaker is get as much ampacity into a particular frame size as possible while considering AIC or SCCR ratings, wire sizes, contact sizes, etc. Increasing ampacity of a particular circuit breaker housing size is desirable.

Choice of materials for circuit breaker housings are driven by electrical characteristics as well as other factors, such as flammability, strength, cost, etc. Typically, a circuit breaker housing material has good insulation characteristics, which typically eliminates conductive materials, such as metal. Often circuit breaker housings are constructed of materials that are a thermoplastic resin such as polyamides and nylons (which is a type of polyamide), both of which have good electrical insulating characteristics in addition to other desirable characteristics.

One desirable characteristic of circuit breaker housing material is an ability to be easily shaped into an appropriate form. One common method for creating a circuit breaker housing is an injection molding process where a heated material, which may be referred to herein as a wall material, is heated to a liquid state and injected into a mold. The wall material is used to construct the walls and other parts of the circuit breaker housing. Once the wall material in the housing mold cools, the wall material hardens into a solid state and the circuit breaker housing is expelled from the housing mold. The AIC and/or SCCR rating of the circuit breaker is dependent on properties of the selected wall material in conjunction with the shape of the circuit breaker housing, thickness of the outer walls of the circuit breaker housing, and the like.

In some embodiments, the wall materials suitable for a circuit breaker housing include materials that perform well in the Comparative Tracking Index ("CTI"), the Glow Wire Flammability Index ("GWFI"), and the Underwriters Laboratories ("UL") 94 flammability test. The Comparative Tracking Index is used to measure the electrical breakdown (e.g., tracking) properties of insulating materials. Tracking is an electrical breakdown on the surface of an insulating material where an initial exposure to electrical arcing carbonizes the material. The carbonized areas are more conductive than the material prior to electrical exposure and lead to increased current flow, resulting in increased heat generation, and eventually the insulation becomes completely conductive. For the Glow Wire Flammability Index, a hot wire is heated to a specific temperature and pressed against the wall material for 30 seconds. If ignition occurs, the duration, flame height and if drips of the material ignite tissue paper are recorded. For the UL 94 flammability test, an open flame is placed a certain distance below the wall material positioned at various angles for a specific period of time and flammability characteristics are noted and give rise to various UL 94 ratings. In embodiments described herein, the wall material is any material that can be injection molded and does well on the CTI test, the GWFI test, the UL 94 flammability test, and/or other relevant tests.

In addition, suitable wall materials have other desirable characteristics selected from such categories as flexibility, material hardness, material weight, material cost, and the like. In some embodiments, a suitable wall material is a polyamide. In some examples, the polyamide is a nylon. In other embodiments, the wall material is a polyester, such as polybutylene terephthalate ("PBT"). In some embodiments, various forms of wall materials are able to be used for injection molding and include suitable electrical characteristics, flammability characteristics, and the like, which make these forms of materials suitable for a circuit breaker housing.

In embodiments described herein, a reinforcement material is embedded in an outer surface of exterior walls of a circuit breaker housing and are positioned in such a way as to strengthen the outer walls of the circuit breaker housing against forces caused by the pressure of an arcing current during short circuit conditions. The reinforcement material, in some embodiments, includes fibers strategically positioned in one or more directions to oppose the forces caused by the pressures of short circuit arcing.

Beneficially, having the reinforcement material embedded in an outer surface of a circuit breaker housing 100 provides various benefits. In some examples, the walls of the circuit breaker housing 100 can be thinner than circuit breaker housings without the reinforcement material. In other examples, a circuit breaker housing 100 with reinforcement material embedded in outer walls allows for higher short circuit current ratings, which allows for a higher ampacity for a same size frame. For example, a 100 A frame size may be used for a 125 A circuit breaker where reinforcement material is added to the circuit breaker housing 100. One of skill in the art will recognize other benefits of a circuit breaker housing 100 with a reinforcement material embedded in outer walls of the circuit breaker housing 100.

Figure 2 is a diagram 200 of a circuit breaker housing 100 with reinforcement material 202 on one side, according to various embodiments. In the diagram 200 of Figure 2, the reinforcement material 202 is positioned to cover an outer surface of the circuit breaker housing 100. While the reinforcement material 202 is depicted on one outer surface of the circuit breaker housing 100, in other embodiments, the reinforcement material 202 covers other outer surfaces of the circuit breaker housing 100. The pattern of the reinforcement material 202 in Figure 2 is merely meant to distinguish the reinforcement material 202 from other materials and surfaces of the circuit breaker housing 100 and is not intended to depict actual direction of the fibers of the reinforcement material 202.

In some embodiments, fibers of the reinforcement material 202 run in a single direction (e.g., unidirectional). For example, the fibers of the reinforcement material 202 may run side-to-side, top-to-bottom or at a particular angle with respect to the circuit breaker housing 100. In other embodiments, the reinforcement material 202 include multiple layers of fibers running in different directions. In some examples, a first layer has fibers running in a first direction and a second layer with fibers running perpendicular to the first direction. In some embodiments, the reinforcement material 202 has two or more layers pressed or otherwise bound together.

In some embodiments, the reinforcement material 202 is impregnated with a bonding material capable of bonding to the heated wall material when heated. In some examples, the bonding material is similar to the wall material with chemical properties, insulating properties, etc. similar to the wall material. In some embodiments, the bonding material has a melting point similar or less than the wall material and softens sufficiently during injection molding to bond to the wall material. In some embodiments, the bonding material is the same as the wall material.

In some embodiments, the reinforcement material 202 impregnated with the bonding material is heated prior to injection molding. In some examples, the reinforcement material 202 impregnated with the bonding material is heated to a temperature so that the thermal energy of coming in contact with the wall material during injection molding causes the bonding material to melt and bond to the wall material. In the examples, failure to heat the reinforcement material 202 impregnated with the bonding material or failure to heat the reinforcement material 202 impregnated with the bonding material to a proper temperature may cause insufficient bonding between the reinforcement material 202 and the wall material. Thus, the reinforcement material 202 is heated to a sufficient temperature just before coming in contact with the wall material during injection molding.

The reinforcement material 202 typically includes a material with fibers running in a particular direction. The fibers are of a material such that the reinforcement material 202 is strong with regard to forces in a direction of the fibers and may be weaker in other directions. The fibers may be fiberglass, carbon fiber, or other suitable material. In some embodiments, the reinforcement material 202 has good insulation properties. In some embodiments, conductive fibers, such as metal, are excluded. In some embodiments, the reinforcement material 202 comes in the form of a tape. In other embodiments, the reinforcement material 202 come in the form of a sheet. In some embodiments, the reinforcement material 202 has fibers running in multiple directions. For example, the reinforcement material 202 may include fibers in a first direction and other fibers running perpendicular to the to the first direction. In other embodiments, the reinforcement material 202 has more than two layers of fibers. In other embodiments, the layers of fiber are pressed, glued, bonded, etc. together into the reinforcement material 202.

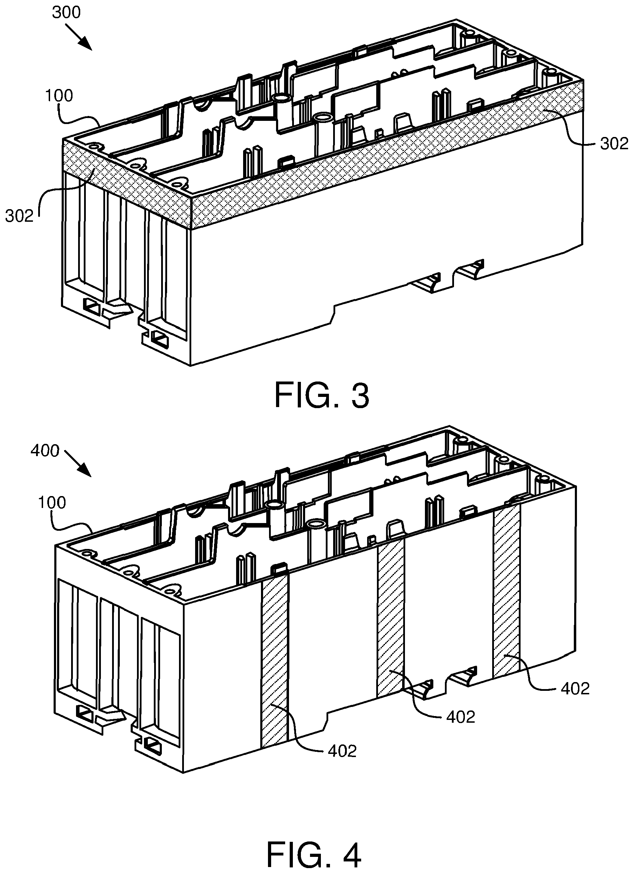

Figure 3 is a diagram 300 of a circuit breaker housing 100 with reinforcement material 302 around the circuit breaker housing 100, according to various embodiments. The reinforcement material 302, in some embodiments, is the same material as the reinforcement material 202 of Figure 2. In some embodiments, the reinforcement material 302 wraps around two or more adjacent sides of the circuit breaker housing 100. In some examples, the reinforcement material 302 wraps along an entire side and then partially around adjacent sides to provide additional strength. In other embodiments, the reinforcement material 302 wraps in a loop around four adjacent sides of the circuit breaker housing 100. While the reinforcement material 302 is depicted in a narrow band in Figure 3, in other embodiments, the reinforcement material 302 is wider. In other embodiments, the reinforcement material 302 is wrapped around the circuit breaker housing in multiple locations. In various embodiments, the reinforcement material 302 is strategically added to various locations to reinforce the outer walls of the circuit breaker housing 100 at particular points.

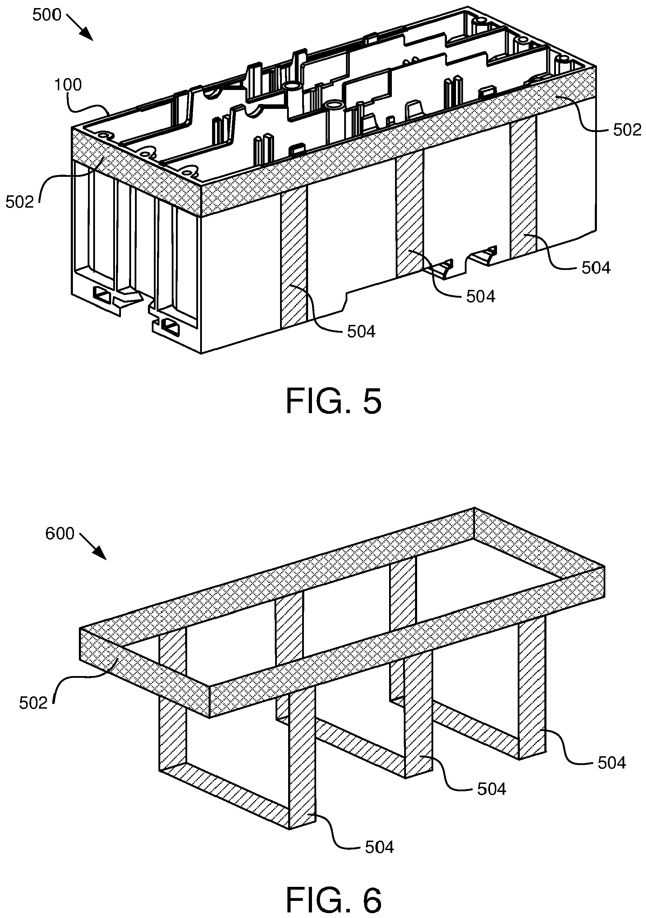

Figure 4 is a diagram 400 of a circuit breaker housing 100 with reinforcement material 402 in U-shaped strips, according to various embodiments. The reinforcement material 402 is similar to the material of the reinforcement material 202 in Figure 2. In Figure 3, the reinforcement material 402 is depicted on a single side but also wraps under and behind the circuit breaker housing 100 as depicted in Figure 6. The U-shaped reinforcement material 402 are placed as needed to add additional reinforcement to the outer walls of the circuit breaker housing 100. U-shaped strips of the reinforcement material 402 may be necessary in certain directions to avoid an open side of the circuit breaker housing 100.

Note that the reinforcement material 402 in Figure 4 has a different pattern different than the pattern of the reinforcement material 302 of Figure 3. The pattern is meant only for convenience to depict the reinforcement material 402 and is not meant to depict direction of fibers. In some embodiments, fibers of the reinforcement material 402 as well as the fibers in the band of reinforcement material 302 in Figure 3 run in the direction of the bands of reinforcement materials 302, 402. In other embodiments, the reinforcement materials 302, 402 include one or more additional layers with fibers of a layer running in a direction different than the bands of reinforcement materials 302, 402.

Figure 5 is a diagram 500 of a circuit breaker housing 100 with reinforcement material in a band 502 around a top portion and U-shaped strips 504. The band 502 and U-shaped strips 504, in some embodiments, are a combination of the reinforcement material 302, 402 of Figures 3 and 4. In some embodiments, the U-shaped strips 504 are connected to the band 502. In other embodiments, the U-shaped strips 504 are not connected to the band 502. Figure 6 is a diagram 600 of an isolated view of the reinforcement material 502, 504 of the circuit breaker housing 100 of Figure 5, according to various embodiments. The band 502 and U-shaped strips 504 of reinforcement material add a cage-like design, which would be less expensive than to wrap the outer surfaces as depicted in Figure 2. One of skill in the art will recognize other designs of reinforcement material to be placed on and bonded to a wall material of a circuit breaker housing 100.

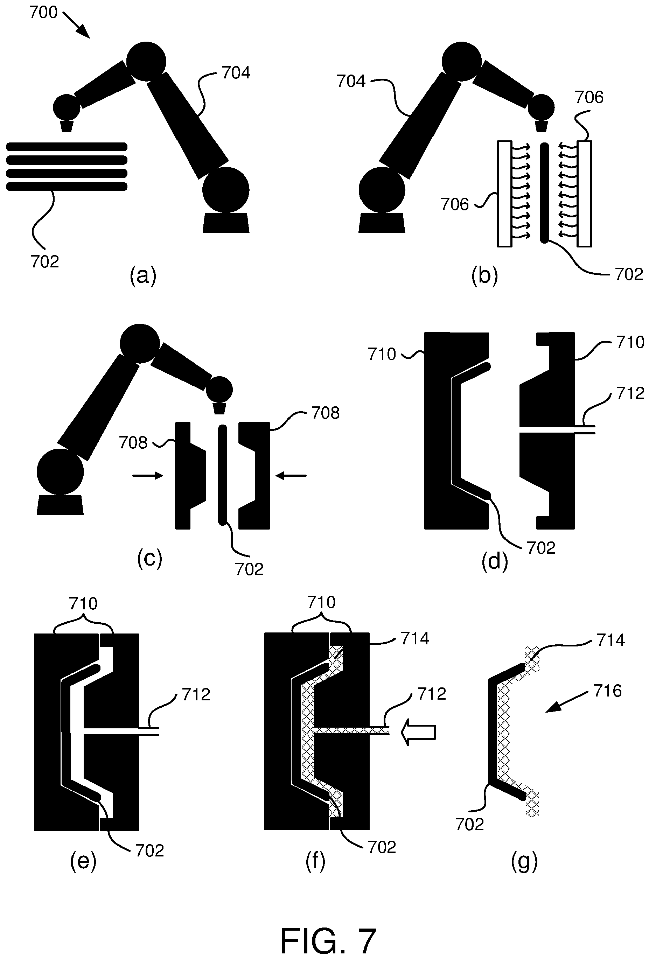

Figure 7 is a diagram illustrating a process 700 for creating a portion of a circuit breaker housing 100 with heated reinforcement material 702, according to various embodiments. The process 700 begins with a sheet of reinforcement material 702 being picked up (a) by a robotic arm 704 and placed (b) in a heater 706. In other embodiments, a robotic arm 704 is not used and some other mechanism or person moves the reinforcement material 702. In some embodiments, the heater 706 includes an infrared heat source. In other embodiments, the heater 706 is an oven. In other embodiments, the heater 706 includes electric heat elements. The heater 706, in other embodiments, uses natural gas for heating. One of skill in the art will recognize other types of heaters 706.

The process 700 places (c) a heated sheet of reinforcement material 702 in a reinforcement mold 708 where the sheet of reinforcement material 702 is pressed into a particular shape. The heated reinforcement material 702 is rotated and placed (d) to a housing mold 710 with an opening 712 for injection molding. The housing mold is moved (e) together and heated wall material is injected (f) into the housing mold 710 through one or more openings 712. The finished part 716 includes wall material 714 and reinforcement material 702 on an exterior surface. Note that the finished part 716 is intended to represent a circuit breaker housing 100 where depiction of the entire circuit breaker housing 100 in each step of the process 700 of Figure 7 would be difficult in terms of clarity. As contemplated herein, the process 700 of Figure 7 is applicable to an entire circuit breaker housing 100. The circuit breaker housing 100 may be constructed in a single injection molding process or multiple injection molding processes.

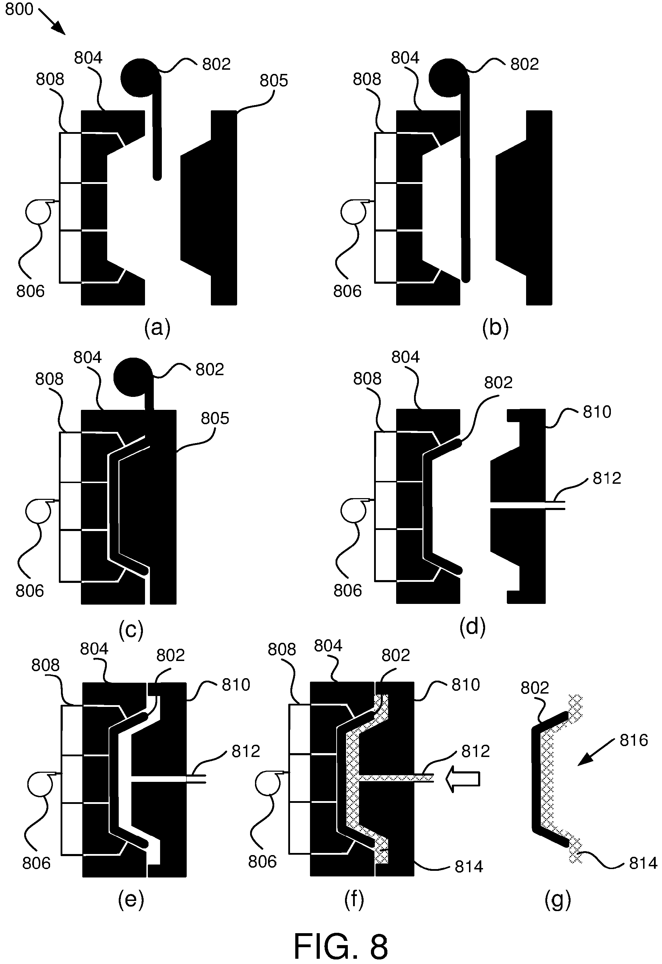

Figure 8 is a diagram illustrating a process 800 for creating a portion of a circuit breaker housing 100 by placing reinforcement material 802 in a housing mold with a first section 804 and a positioning piece 805 and holding the reinforcement material 802 in place with a vacuum 806 before an injection process, according to various embodiments. The process begins with the housing mold 804, 805 open and the reinforcement material 802 being fed (a) into the housing mold 804, 805. The reinforcement material 802 is depicted in a roll but may be a sheet or other suitable form. The housing mold first section 804 includes vacuum ports 808 intended to hold the reinforcement material 802 in place using a vacuum force exerted by the vacuum 806.

The process 800 extends (b) the reinforcement material 802 to a particular length and closes (c) the positioning piece 805 of the housing mold to press the reinforcement material 802 against the first section 804 of the housing mold. The process 800 operates the vacuum 806 in conjunction with the vacuum ports 808 to hold the reinforcement material 802 in place and moves (d) a second section 810 of the housing mold with an opening 812 for injection material into place and then moves (e) against the first section 804 while the vacuum 806 continues to hold the reinforcement material 802 in place. The process 800 injects (f) heated wall material 814 into the opening 812 to fill the space behind the reinforcement material 802. The process 800 extracts (g) the final part 816 from the housing mold 804, 810 and includes wall material 814 with the reinforcement material 802 on an exterior surface.

Note that as with the process 700 of Figure 7, the finished part 816 is intended to represent a circuit breaker housing 100 where depiction of the entire circuit breaker housing 100 in each step of the process 800 of Figure 8 would be difficult in terms of clarity. As contemplated herein, the process 800 of Figure 8 is applicable to an entire circuit breaker housing 100. The circuit breaker housing 100 may be constructed in a single injection molding process or multiple injection molding processes. Note also that while the process 800 of Figure 8 depicts a positioning piece 805 in addition to a second section 810 of the housing mold, in other embodiments the second section 810 is used to move the reinforcement material 802 close enough for the vacuum ports 808 to take effect and to suck the reinforcement material 802 against the first section 804 of the housing mold.

In other embodiments, the positioning piece 805 is shaped differently. For example, the positioning piece 805 may include arms, rods, etc. that may be moved to push the reinforcement material 802 into place. In some embodiments, a location where the reinforcement material is 802 is flat and applying a vacuum force is sufficient to pull the reinforcement material 802 into place without a positioning piece 805. One of skill in the art will recognize other methods of moving the reinforcement material 802 into position so that vacuum forces are able to hold the reinforcement material 802 into place.

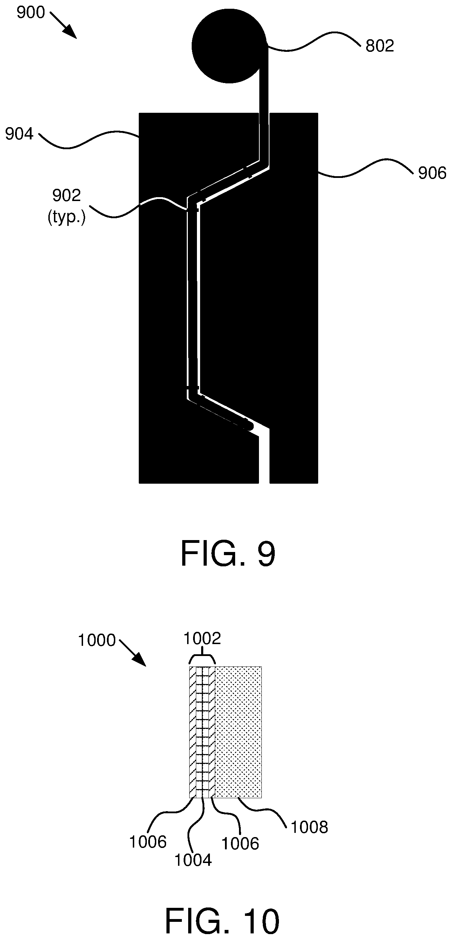

Figure 9 is a diagram 900 illustrating a housing mold for placement of a reinforcement material 802 in position held by pins 902, according to various embodiments. The housing mold has a first section 904 and a second section 906. As the second section 906 moves toward the first section 904, in some embodiments the second section 906 presses the reinforcement material 802 onto the pins 902. In other embodiments, after the second section 906 positions the reinforcement material 802, the pins 902 move into place to hold the reinforcement material 802. In other embodiments, the second section 906 is a section of the housing mold. In other embodiments, the second section 906 includes arms, rods, discrete parts, etc. that move the reinforcement material 802 into place on the pins 902. While examples of holding the reinforcement material 802 in place include use of a vacuum force and pins, other methods may also be used, such as gluing the reinforcement material 802 in place using hot melted plastic, wall material, bonding material, or the like. In other embodiments, the glue is another material that is not heated. One of skill in the art will recognize other ways to hold the reinforcement material 802 in place until heated wall material is injected into a housing mold.

Figure 10 is a diagram illustrating a cross section 1000 of a reinforcement material 1002 bonded to an injected wall material 1008, according to various embodiments. The reinforcement material 1002 includes fibers 1004 embedded with bonding material 1006. The bonding material 1006 is depicted on both sides of the fibers 1004 for convenience but typical reinforcement material 1002 includes a bonding material 1006 impregnated into the fibers 1004. At the interface between the bonding material 1006 and the injected wall material 1008, the injected wall material 1008 is bonded to the bonding material 1006 as the heated injected wall material 1008 melts the bonding material 1006. In other embodiments, the reinforcement material 1002 does not include the bonding material 1006 and the heated injected wall material 1008 bonds to the fibers 1004 of the reinforcement material 1002.

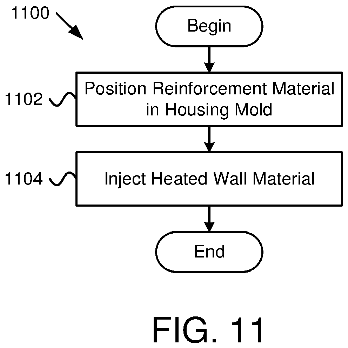

Figure 11 is a schematic flowchart diagram illustrating a method 1100 for creating a circuit breaker housing 100 using an injected wall material with a reinforcement material along an outer surface, according to various embodiments. The method 1100 begins and positions 1102 a reinforcement material (e.g., 202, 302, 402, 502, 504, 702, 802, 1002) in a housing mold (e.g., 710, 804, 805 810, 904, 906) for a circuit breaker housing 100. The circuit breaker housing 100 includes outer walls on at least four sides and the reinforcement material is positioned to be on an outer surface of one or more of the at least four sides.

The method 1100 injects 1104 a heated wall material (e.g., 714, 814, 1008), using an injection molding process, in a portion of the housing mold interior to the reinforcement material to form the circuit breaker housing 100, and the method 1100 ends. The heated wall material bonds to the reinforcement material as the heated wall material is injected in the housing mold and the reinforcement material is in the outer surface of the one or more of the at least four sides of the circuit breaker housing 100.

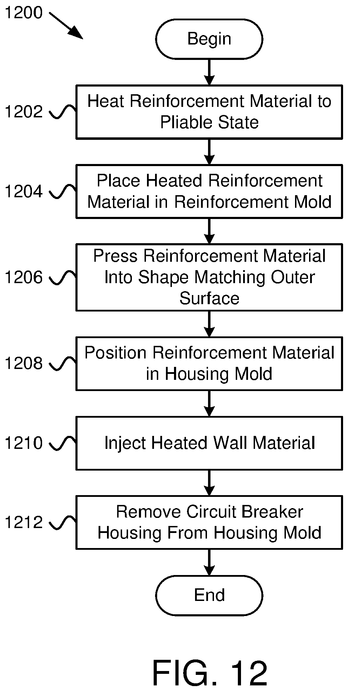

Figure 12 is a schematic flowchart diagram illustrating a method 1200 for creating a circuit breaker housing 100 using an injected wall material with a reinforcement material along an outer surface where the reinforcement material is heated and pressed into shape, according to various embodiments. The method 1200 is similar to the process 700 of Figure 7. The method 1200 is applicable to reinforcement material (e.g., 202, 302, 402, 502, 504, 702, 1002) impregnated with bonding material 1006. The method 1200 begins and heats 1202 reinforcement material to a pliable state and places 1204 the heated reinforcement material in a reinforcement mold (e.g., 708) and presses 1206 the heated reinforcement material into the reinforcement mold. The method 1200 positions 1208 the shaped reinforcement material into a housing mold (e.g., 710) and injects 1210 heated wall material (e.g., 714) into the housing mold and removes 1212 the formed circuit breaker housing 100 from the housing mold, and the method 1200 ends.

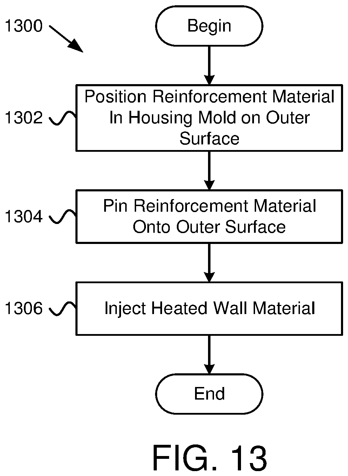

Figure 13 is a schematic flowchart diagram illustrating a method 1300 for creating a circuit breaker housing 100 using an injected wall material with a reinforcement material along an outer surface where the reinforcement material is positioned in a mold and pinned in position, according to various embodiments. The method 1300 begins and positions 1302 reinforcement material (e.g., 202, 302, 402, 502, 504, 702, 902) in a housing mold 904, 906 such that the reinforcement material will be positioned on an outer surface of a circuit breaker housing 100. The method 1300 pins 1304 the reinforcement material in position and injects 1306 a heated wall material 814, using an injection molding process, in a portion of the housing mold interior to the reinforcement material to form the circuit breaker housing 100, and the method 1300 ends.

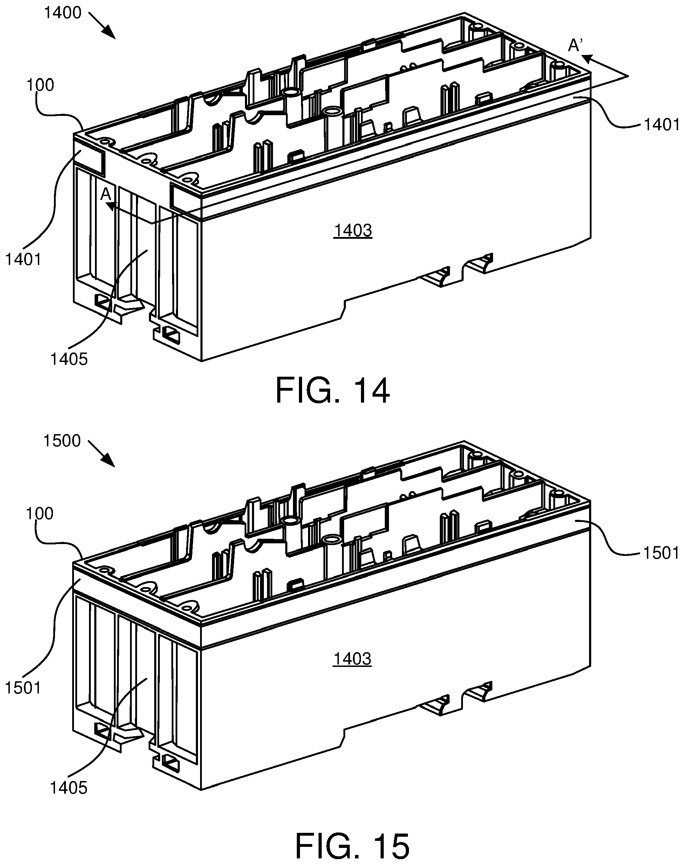

Figure 14 is a diagram 1400 of a circuit breaker housing 100 with reinforcement elements 1401 extending along reinforced sides 1403 of the housing 100 and partially along sides 1405 [hereinafter "adjacent sides"] adjacent to the reinforced sides 1403, according to various embodiments. As mentioned above, a circuit breaker of the circuit breaker housing 100 is designed to open the contacts of the circuit breaker during a short-circuit current event. Short circuit events and associated opening of the circuit breaker contacts cause a high level of pressure to build within the housing 100. The pressure can cause a deformation of one or more sides of the housing 100. Longer sides of the housing 100 may be especially prone to this deformation, especially adjacent to the open top side of the housing 100. Other sides are naturally stronger because of shorter lengths, connections to other sides, etc. A reinforcement element 1401 may be positioned against a reinforced side 1403 in order to keep the reinforced side 1403 side in place and limit expansion of the reinforced side 1403.

In some embodiments, the housing 100 includes a recess for each reinforcement element 1401 to accommodate the reinforcement element 1401. In some embodiments, the recess is sized such that an outer surface of the reinforcement elements 1401 are flush with other portions of the reinforcement sides 1403 and/or adjacent sides 1405 to not increase dimensions of the housing 100. In other embodiments, one or more recesses in the housing 100 allow the reinforcement elements 1401 to protrude a small amount. In other embodiments, the housing 100 does not include a recess and the reinforcement elements 1401 are placed on the outside of the housing 100.

In some embodiments, the recess in the housing 100 is below the top side of the housing 100, as depicted in Figure 14. In the embodiments, the recess has material of the housing 100 above (e.g., toward an area above the top side of the housing 100) and below the reinforcement element 1401. In other embodiments, the recess is positioned so that a top of the reinforcement element 1401 is exposed. In the embodiments, the recess is behind the reinforcement element 1401 in a direction toward the housing 100 and below the reinforcement element 1041 toward a bottom side of the housing 100, which is opposite the top side of the housing 100.

As used herein, a short circuit event includes a bolted fault or any other condition that causes pressure buildup within the circuit breaker housing 100. A bolted fault is where resistance of the fault plus wiring leading up the fault are at an expected minimum resistance, which typically causes a very high fault current through the circuit breakers in the circuit breaker housing 100. In such a condition, fault resistance is minimal and wiring to the fault is minimized. Often, the AIC or SCCR of a circuit breaker is chosen based on an expected maximum short circuit current due to impedance leading up to a circuit breaker with a bolted fault downstream of the circuit breaker. Circuit breakers and associated circuit breaker housing 100 are designed around a particular AIC or SCCR, which typically causes a maximum amount of pressure and other forces within a circuit breaker. A short circuit event may also include bolted faults or other higher impedance faults that cause pressure within the circuit breaker housing 100.

Forming a circuit breaker housing 100 from materials with adequate stiffness and strength to limit deformation along weakest areas requires the entire housing 100 to be made of a material designed for the weakest points, which can be more costly than having a separate reinforcement element 1401 to strengthen weak points of the housing 100. Furthermore, slight deformation may be preferred to effect a release a certain amount of pressure from the housing 100.

The reinforcement element 1401, in some embodiments, allows the housing 100 to be made of a softer, less expensive material where the reinforcement element 1401 provides support for the weakest parts of the housing 100. In some embodiments, the reinforcement elements 1401 are constructed of a material that is stronger and/or stiffer than material of the housing 100. The reinforcement element 1401 of Figure 14 is shaped to support a top edge of the housing 100 on the reinforced side 1403 adjacent to the opening in the housing 100, which is typically a weak point.

In some embodiments, the housing 100 includes a material and a design such that pressure formed during a short circuit event causes the reinforced side 1403 to expand past a desired point of expansion. The reinforcement elements 1401 are placed externally to the sides of the housing 100 subject to deformation outward from an interior of the housing 100 during a short circuit event. In some embodiments, the reinforcement element 1401 is positioned against the housing 100 and includes a material and a design to limit expansion of the reinforced side to the desired point of expansion.

In some embodiments, the circuit breaker housing 100 is designed to contain gases during a short circuit event, so a desired point of expansion is a point where the reinforced sides 1403 are kept against a circuit breaker, a cover, or other element encompassing the open top of the circuit breaker housing 100 so that gases from a short circuit event are not allowed to escape. In the embodiments, a desired point of expansion includes a top edge of the circuit breaker housing 100 on a reinforced side 1403 under a reinforcement element 1401. In the embodiment, the material of the circuit breaker housing 100 without the reinforcement element 1401 may expand beyond the desired point of expansion. With the reinforcement element 1401 included the reinforcement element 1401 supports the top edge of the circuit breaker housing 100 to limit expansion to the desired point of expansion such that gases from a short circuit event do not escape from the circuit breaker housing 100.

In another embodiment, the circuit breaker housing 100 is designed to allow a certain amount of gases during a short circuit event to escape. A desired point of expansion in the embodiments is a point where the reinforced sides 1403 expand enough so that a small gap is formed between the top of the circuit breaker housing 100 and a circuit breaker, a cover, or other element encompassing the open top of the circuit breaker housing 100 so that a certain amount of gases from a short circuit event escape. In the embodiments, the material of the circuit breaker housing 100 without the reinforcement element 1401 expands past the desired point of expansion. In the embodiments, the reinforcement element 1401 is designed to limit expansion of the top edge of the circuit breaker housing 100 on the reinforced side 1403 to the desired point of expansion.

In some embodiments, the desired point of expansion is a point located outwards from an edge of a reinforced side 1403. In the embodiments, the desired point of expansion is determined prior to attaching the reinforcement element 1401 to the housing 100. A point at which the reinforcement element 1401 is attached to the housing 100 is determined based on the desired point of expansion. For example, if the desired point of expansion is 1 millimeter ("mm") away from the edge of the reinforced side 1403 in a normal condition, the reinforcement element 1401 may be attached to the housing 100 at a point on the housing 100 such that there is a gap of 1 mm between the edge of the reinforced side 1403 in a normal condition and the reinforcement element 1401. The desired point of expansion may be based, for example, on a material of the housing 100 and/or on an amount of gases that would optimally escape from the housing 100 during a short circuit event.

In some embodiments, the reinforcement element 1401 is made of a stiffer material than the housing 100. In other embodiments, the reinforcement element 1401 is made of a same material as the housing 100 and provides extra thickness at a weak point of the housing 100 to limit expansion to the desired point of expansion. In other embodiments, reinforcement elements 1401 may be of different stiffnesses which may be applied to a housing 100 to comply with different short circuit current requirements and to limit expansion to the desired point of expansion while the housing 100 is a same design for each short circuit current requirement. One of skill in the art will recognize other materials with various stiffnesses suitable for a reinforcement element 1401.

As shown in Figure 14, the housing 100 may include two or more reinforced sides 1403, each with a reinforcement element 1401. In some embodiments, the housing 100 may have four reinforced sides 1403 with a reinforcement element 1401. A reinforced side 1403 of the housing 100 may be any side of the housing 100. The reinforcement elements 1401 are designed to be mounted onto the reinforced sides 1403. Although Figure 14 illustrates two reinforced sides 1403 and two reinforcement elements 1401, embodiments of the present disclosure are not so limited. For example, in certain embodiments, there may be only one reinforcement element 1401 mounted to a single reinforced side 1403.

A reinforcement element 1401 is constructed of one or more materials that resist expansion of at least the portion of the reinforced side 1403 covered by the reinforcement element 1401. In some embodiments, a reinforcement elements 1401 includes a similar material as the circuit breaker housing 100, such as a plastic. In other embodiments, the reinforcement elements 1401 include another material such as a resin. In other embodiments, the reinforcement elements 1401 are constructed with fibers. The fibers may be in addition to or embedded in a plastic, resin, etc. In some embodiments, the fibers run in a direction along a length of the circuit breaker housing 100 between ends of the reinforcement elements 1401 attached to the circuit breaker housing 100. In other embodiments, the fibers run in multiple directions. In various embodiments, the fibers are fiberglass, carbon fiber, or other suitable fiber material. In some embodiments, the reinforcement elements 1401 include a tape. The tape may include fibers or other material designed to strengthen the reinforced sides 1403. One of skill in the art will recognize other materials and combinations of materials for construction of the reinforcement elements 1401.

The reinforcement elements 1401 are formed separately from the circuit breaker housing 100. For example, reinforcement elements 1401 may be formed through injection molding. In some embodiments, reinforcement element 1401 may be formed from plastic with fibers embedded throughout to strengthen the material. Reinforcement element 1401 may also include a metallic material coated with plastic.

In some embodiments, a reinforcement element 1401 may be a bracket, a clip, or a tensile bar. A reinforcement element 1401, in some embodiments, is configured to absorb a high tensile load. A reinforcement element 1401 may be flexible enough to expand to a certain degree and/or to bend slightly for attachment and detachment purposes. In other embodiments, the housing 100 may also be flexible to some degree to accommodate the reinforcement element 1401 being snapped into place or otherwise attached to the housing 100.

The reinforcement element 1401, in some embodiments, is configured to extend along a length of the circuit breaker housing 100. In such embodiments, the length of the circuit breaker housing 100 is a reinforced side 1403. In the embodiments, the reinforcement element 1401 wraps around and covers a portion of the adjacent sides 1405 of the housing. As shown in Figure 14, in some embodiments a reinforcement element 1401 includes a portion at each end of the reinforced side that wraps around and covers a portion of two adjacent sides 1405 that are adjacent to the reinforced side 1403. In the embodiments depicted in Figure 14, the reinforcement element 1401 is attached to the housing 100 on the two adjacent sides 1405 adjacent to the reinforced side 1403. In some embodiments, the reinforcement element 1401 is connected to the circuit breaker housing 100 on the adjacent sides 1405 and at least a portion of the reinforced side 1403.

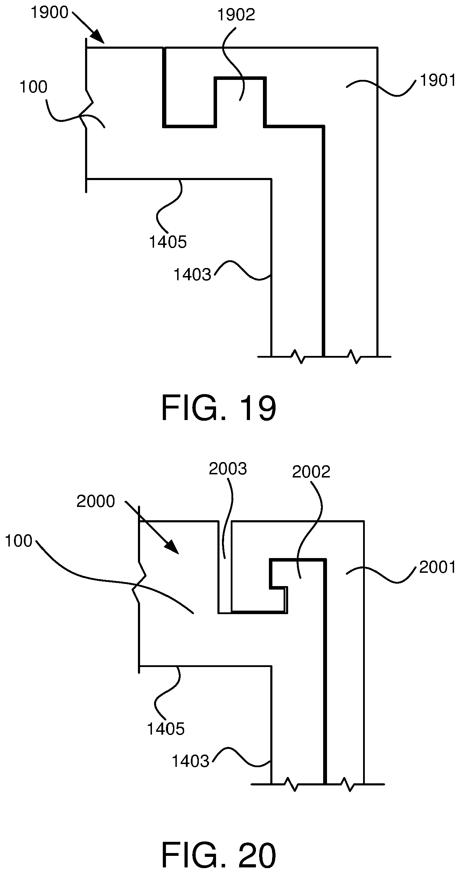

In some embodiments, the reinforcement element 1401 is connected to the housing 100 via a weld, connector, an adhesive, or the like at least at each end of the reinforcement element. For example, a reinforcement element 1401 may be attached to the housing 100 as shown in Figures 19-24.

As shown in Figure 14, the housing 100 includes a top side that is open and a bottom side that is closed. Having a closed bottom side, in some embodiments, provides more rigidity along a bottom of the reinforced side 1403 than the open top edge of the reinforced side 1403 so that a reinforcement element 1401 may not be needed along a bottom edge of the reinforced side 1403. Thus, in the embodiments of Figure 14 the reinforcement element 1401 is located on the reinforced side 1403 of housing 100 along a top portion adjacent to the top side of the housing 100.

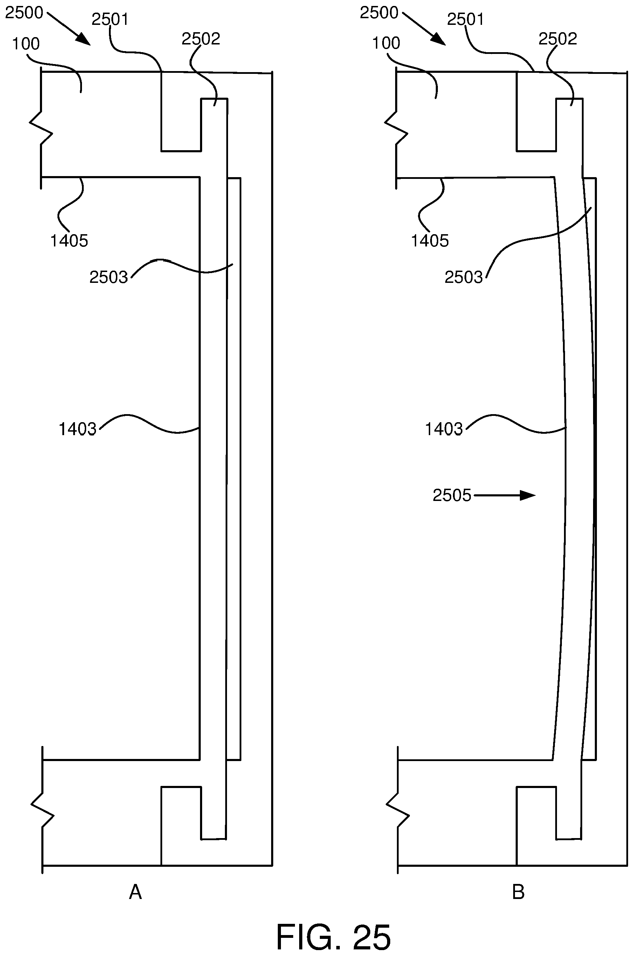

In some embodiments, the reinforcement element 1401 is mounted to the housing 100 at a most likely place of expansion to limit expansion of the housing 100 to the desired point of expansion. For example, if it is desired that a reinforced side 1403 does not expand at all, a reinforcement element 1401 may be mounted directly against the reinforced side 1403, which may be in a recess, without any intended flexibility to move. If the desired point of expansion is a few millimeters away from a starting point of the reinforced side 1403, a reinforcement element 1401 may either be (i) mounted directly against the reinforced side 1403 in a recess with the flexibility to expand to the desired point of expansion or (ii) mounted to the reinforced side with a gap between the starting point of the reinforced side 1403 and the reinforcement element 1401 (as shown in Figure 25 drawing A), such that the reinforced side 1403 expands to meet the reinforcement element 1401 in the event of a short circuit condition (as shown in Figure 25 drawing B). The reinforcement element 1401 allows for the housing 100 to be composed of material that is not a stiff or as strong as would be required to prevent expansion past the desired point of expansion without reinforcement element 1401.

Figure 15 is a diagram 1500 of a circuit breaker housing 100 with a reinforcement element 1501 around the circuit breaker housing 100. As shown in Figure 15, the housing 100 includes four sides, and a reinforcement element 1501 wraps around the four sides of the housing 100.

In the embodiments, the reinforcement element 1501 may cover a top portion of the housing 100 as depicted in Figure 15. This top portion may be adjacent to the top side of the housing 100. However, the top portion may also be below the top side of the housing 100. The reinforcement element 1501 may be continuous. In some embodiments, the reinforcement element 1501 is mounted directly against each side of the housing 100 in a recess. In other embodiments, there is a gap between the reinforcement element 1501 and at least one of the sides of the housing 100. In some embodiments, the housing 100 includes a recess along a top part of the housing 100 so that the reinforcement element 1501 is able to be slid down into the recess. In other embodiments, the reinforcement element 1501 and/or the housing 100 are flexible enough to get the reinforcement element 1501 into the recess.

As shown in Figure 15, reinforcement element 1501 may be of a length equal to the length of the housing 100. Reinforcement element 1501 may be wider than the housing 100. However, embodiments of the present disclosure are not so limited. For example, the reinforcement element 1501, in some embodiments, is both longer and wider than the housing 100 so that the reinforcement element 1501 protrudes from a recess or is mounted on an outside . In other embodiments, the reinforcement element 1501 is of an equal width as the housing but a longer length.

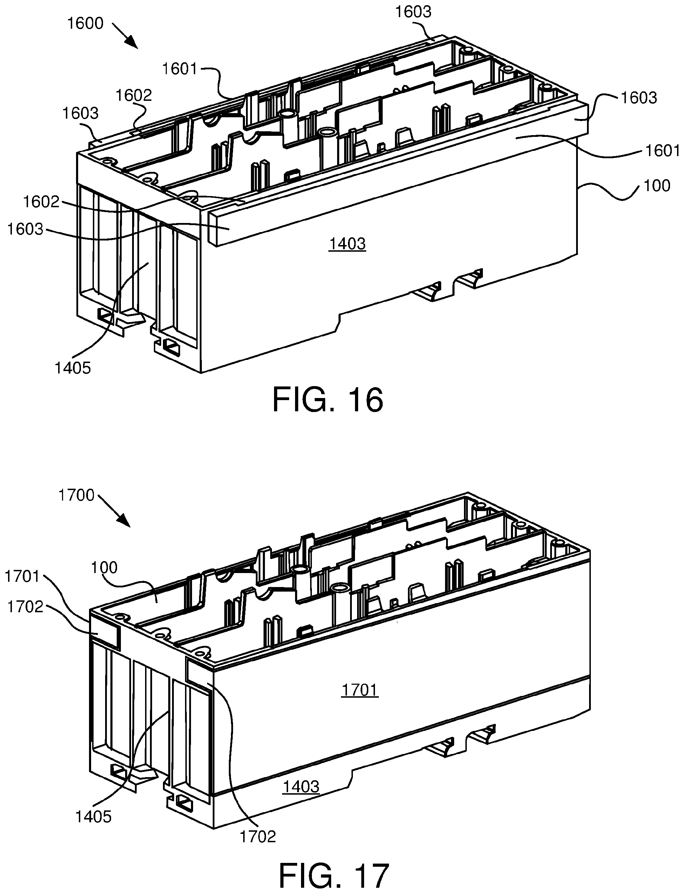

Figure 16 is a diagram 1600 of a circuit breaker housing 100 with reinforcement elements 1601 along portions of two sides 1403 of the circuit breaker housing with a gap in the reinforcement element 1601, according to various embodiments. These two sides are reinforced sides 1403. Certain embodiments may include a gap 1602 between a portion of the reinforcement element 1601 and a reinforced side 1403. In some embodiments, this gap is configured to allow for the expansion of the circuit breaker housing 100 to a desired point of expansion. While the reinforcement element 1601 is shown on an external surface of the reinforcement side 1403, in some embodiments, the reinforcement elements 1601 is in a recess in the housing 100.

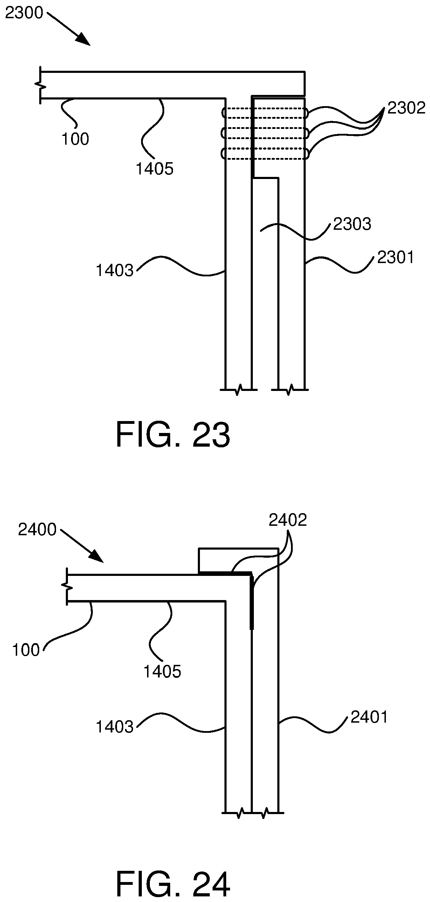

In some embodiments, the reinforcement element 1601 does not wrap around to an adjacent side 1405 of the housing 100, as depicted in Figure 16. In the embodiments, the reinforcement element 1401 is mounted directly to reinforced side 1403, either to a surface or within a recess of the reinforcement side 1403. Where the reinforcement element 1601 includes a gap 1602, the reinforcement element 1601 is connected at an end 1603. The reinforcement element 1601, in various embodiments, is mounted to an end 1603 the reinforced side 1403 by welding, adhesive, connectors, rivets, or the like. Connection by rivets is illustrated in Figure 23. In some embodiments, the reinforcement element 1601 is mounted to reinforced side 1403 at a portion that is unlikely or less likely to expand with pressure, such as near an end of the housing 100.

Figure 17 is a diagram 1700 of a circuit breaker housing 100 with reinforcement elements 1701 on two sides 1403, according to various embodiments. The reinforcement element 1701 is depicted in a recess in Figure 17, but may also be on an exterior surface of the housing 100 without a recess. As shown in Figure 17, in some embodiments, a reinforcement element 1701 almost completely covers a reinforced side 1403 of the housing 100. In some embodiments, the reinforcement element 1701 completely covers a reinforced side 1403 of the housing 100. In some embodiments, the reinforcement elements 1701 include a section 1702 that wraps around a portion of two adjacent sides 1405 of the housing 100 that are adjacent to the reinforced side 1403. The portion of the adjacent sides 1405 around which reinforcement elements 1701 wrap may be a top portion of the adjacent side 1405.

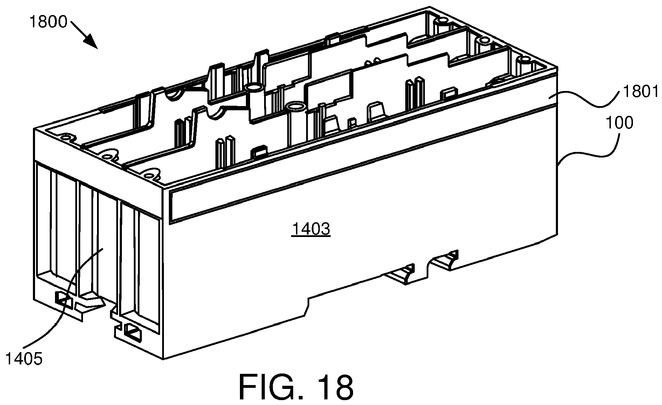

Figure 18 is a diagram 1800 of a circuit breaker housing 100 with reinforcement elements 1801 along portions of two reinforcement sides 1403, according to various embodiments. The reinforcement element 1801 is depicted in a recess of the reinforcement side 1403, but may be mounted on a reinforcement side 1403 without a recess. In the embodiments of Figure 18, the reinforcement element 1801 does not wrap around adjacent sides 1405 adjacent to reinforced sides 1403 and does not include a gap. The reinforcement element 1801 is attached directly to reinforced side 1403. In various examples, the reinforcement element 1801 may be welded to reinforced side 1403, attached via adhesive, attached with rivets, or the like.

Although Figures 19-24 illustrate various methods of attaching the reinforcement elements 1401, 1501, 1601, 1701, 1801 to the housing 100, embodiments of the present disclosure are not limited to these methods. The reinforcement elements 1401, 1501, 1601, 1701, 1801 may be attached to the housing 100 in any manner suitable to prevent it from slipping from the housing 100. In addition, the methods of attaching the reinforcement elements 1401, 1501, 1601, 1701, 1801 to the housing 100 may be applied to the adjacent sides 1405 or the reinforced sides 1403 or both, as appropriate.

Figure 19 is an isolated section view of an attachment point 1900 of a reinforcement element 1901, which is representative of any of the reinforcement elements with a portion wrapping around to an adjacent side 1405, such as the reinforcement elements 1401, 1701 depicted in Figures 14 and 17, according to various embodiments. Figure 19, in some embodiments, is a top section view such as section A-A' of Figure 14 such that a top of the recess above the reinforcement element 1901 is not visible. As shown in Figure 19, reinforcement element 1901 is mounted against the reinforced side 1403 and wraps around a portion of at least one adjacent side 1405 adjacent to reinforced side 1403 in a recess. In some embodiments, the reinforcement element 1901 and the housing 100 are configured so the reinforcement element 1901 snaps into place on the housing 100. In some examples, the reinforcement element 1901 snaps into place on the housing 100 with a protrusion 1902 on the housing 100 and a corresponding opening or recess at the end of the reinforcement element 1901.

The reinforcement element 1901 may be formed from a material that is flexible enough to bend slightly to fit around the protrusion of the housing 100 while ensuring that the reinforcement element 1901 remains in place once it has been snapped onto the housing 100. In other embodiments, the housing 100 is also able to flex a small amount for the reinforcement element 1901 to be installed.

Figure 20 is an isolated section view of an attachment point 2000 of a reinforcement element 2001, which again is representative of any of the reinforcement elements with a portion wrapping around to an adjacent side 1405, such as the reinforcement elements 1401, 1701 depicted in Figures 14 and 17, according to various embodiments. As shown in Figure 20, reinforcement element 2001 may extend along a reinforced side 1403 of the housing 100. The housing 100 may include a protrusion 2002, such as the L-shaped protrusion shown in Figure 20. The housing 100, in some embodiments, includes a portion 2003 of a recess in the housing 100 wider than the reinforcement element 2001 to allow the reinforcement element 2001 to be installed. This protrusion may be configured such that the reinforcement element 2001 may be attached to the housing 100 through the protrusion on the housing 100 and a corresponding shape at an end of the reinforcement element 2001. For example, if the protrusion 2002 is L-shaped, reinforcement element 2001 may include another L-shaped protrusion at the end of the reinforcement element 2001 to snap into place with the protrusion 2002 of the housing 100. As such, the reinforcement element 2001 may extend in front of the adjacent side 1405 of the housing 100 that contains the protrusion.

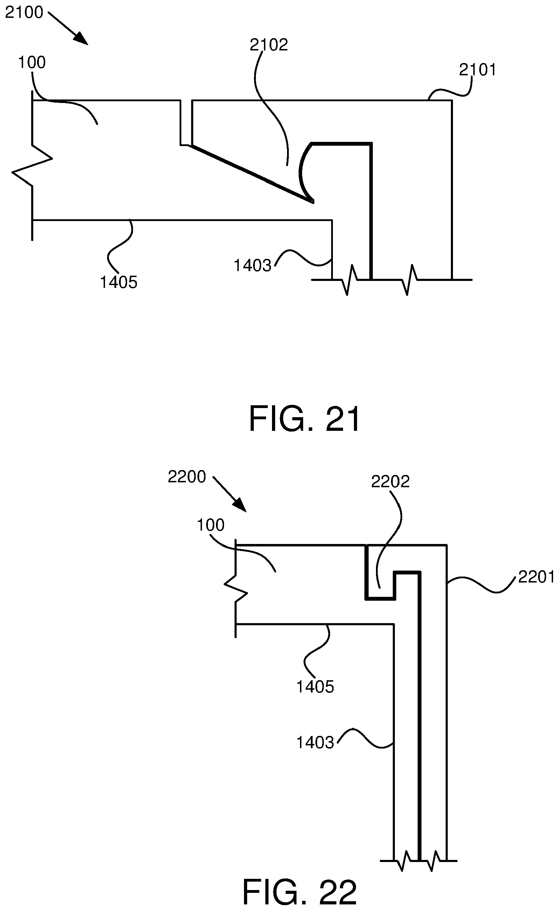

Figure 21 is an isolated section view of an attachment point 2100 of a reinforcement element 2101, which is representative of any of the reinforcement elements with a portion wrapping around to an adjacent side 1405, such as the reinforcement elements 1401, 1701 depicted in Figures 14 and 17, according to various embodiments. As shown in Figure 21, reinforcement 2101 may include a protrusion 2102 that fits into an opening or recess of the housing 100. The opening of the housing 100 may be located on a side 1405 adjacent to the reinforced side 1403. The reinforcement element 2101 may wrap around a portion of the adjacent side 1405.

In some embodiments, the protrusion 2102 is curved, pointed (as depicted in Figure 21), square, rectangular, or the like. In some embodiments, the protrusion 2102 is curved away from the reinforced side 1403. An opening of the housing 100 may also be curved, pointed, square, rectangular, etc. such that the shape of the protrusion 2102 fits into the opening. For example, if the protrusion 2102 is curved away from the reinforced side 1403, the opening of the housing 100 may be curved toward the reinforced side 1403. Such a configuration may keep the reinforcement element 2101 in place and prevent the reinforcement element 2101 from slipping off the housing 100.

Figure 22 is an isolated section view of an attachment point 2200 of a reinforcement element 2201 with a recess in the circuit breaker housing 100 and corresponding protrusion 2202 on the reinforcement element 2201, according to various embodiments. The housing 100 includes a rectangular or square recess 2202 shaped to accommodate a corresponding protrusion on the reinforcement element 2201. In the embodiments, the reinforcement element 2201 is flexible enough to snap into place in on the housing 100 using the recess 2202 in the housing 100.

While the reinforcement elements 1901, 2001, 2101, 2201 of Figures 19-22 are depicted without a gap on the reinforced side 1403 of the housing 100, the connection methods depicted in Figures 19-22 are also applicable to reinforcement elements 1901, 2001, 2101, 2201 with a gap, as depicted in Figure 16.

Figure 23 is an isolated section view of an attachment point 2300 of a reinforcement element 2301 similar to the embodiments of Figure 16 that is attached with rivets 2302, according to various embodiments. As shown in Figure 23, reinforcement element 2301 may be attached to a reinforced side 1403 through one or more rivets 2302. Rivets 2302 may be of any shape that allows them to secure the reinforcement element 2301 to the reinforced side 1403. For example, the rivets 2302 may be cylindrical pins or bolts that are drilled through the reinforcement element 2301 and into the reinforced side 1403.

As shown in Figure 23, the rivets 2302 may be drilled through the portion of the reinforcement element 2301 that does not include a gap 2303. This allows the gap 2303 to remain open for a portion of the reinforced side 1403 to expand into. In some embodiments, the rivets 2302 may be drilled into the reinforced side 1403 and/or an adjacent side 1405 for embodiments that wrap onto the adjacent side 1405, or both.

Figure 24 is an isolated view of an attachment point 2400 of a reinforcement element 2401 similar to the embodiments of Figure 14 where the reinforcement element 2401 is attached to the housing 100 using welds and/or an adhesive, according to various embodiments. While the reinforcement element 2401 is depicted as surface mounted, in other embodiments, the reinforcement element 2401 is recessed. As shown in Figure 24, a reinforcement element 2401 may be configured to fit onto a corner of the housing 100. The reinforcement element 2401 may include a portion extending along a reinforced side 1403 of the housing 100 and another portion that wraps around and extends along a portion of an adjacent side 1405. In some embodiments, the reinforcement element 2401 is secured to the housing 100 through welding or an adhesive material 2402 on the adjacent side 1405, on the reinforced side 1403, or both. For example, as shown in Figure 24, the reinforcement element 2401 may be secured to the housing 100 with a weld 2402 between a portion of the reinforcement element 2401 and the adjacent side 1405 and/or a portion of the reinforced side 1403, or both. An adhesive may also be placed between the housing 100 and the adjacent side 1405 and/or reinforced side 1403.

The reinforcement element 2401 may connect to the housing 100 via a weld or adhesive 2402 at least at each end of the reinforcement element 2401. The reinforcement element 2401 may connect to the housing 100 at each end of the reinforcement element 2401 in addition to along a side of the reinforcement element 2401 that is against the reinforced side 1403.

Figure 25 is a diagram 2500 illustrating a portion of a circuit breaker housing 100 with a reinforced side 1403 and a section view of a reinforcement element 2501 with a gap 2503 during a) a normal condition, and b) during short circuit event, according to various embodiments.

The sides of the housing 100 are formed from material that is prone to expansion when pressure builds within the housing 100. In some embodiments, the housing 100 includes a material and a design such that pressure formed during a short circuit event causes the reinforced side 1403 with the reinforcement element 2501 to expand past a desired point of expansion. In the embodiments, to contain this expansion, a reinforcement element 2501 is attached to the housing 100 to prevent the reinforced side 1403 from expanding beyond a desired point of expansion. The reinforcement element 2501 may include a gap 2503 between the reinforced side 1403 and the reinforcement element 2501. This gap 2503 may allow the reinforced side 1403 of the housing to expand to a certain degree. During a short circuit event, the reinforced side 1403 may expand to the reinforcement element 2501 and to the desired point of expansion. Allowing the housing 100 to expand to a degree may alleviate material constraints for the housing 100 and allow a certain degree of pressure to be released from the housing 100 without deforming the housing 100 beyond a certain point.

During normal operation, as depicted on the left, the reinforced side 1403 is not deformed and the gap 2503 is uniform. During a first stage of pressure release, the reinforced side 1403 may begin to deform slightly, which may start to release some pressure from the housing 100. Throughout this first stage, the reinforced side 1403 expands to fill the gap 2503 as depicted on the right side. In a second stage of pressure release, the reinforced side 1403 contacts the reinforcement element 2501. During this second stage, the reinforcement element 2501 prevents the reinforced side 1403 from expanding beyond a desired point of expansion.

Longer sides may be more prone to this expansion than shorter sides of the housing 100. As such, the reinforcement element 2501 may extend along a reinforced side 1403 that is one of the longer sides of the housing 100. The reinforcement element 2501 may also wrap around a portion of a shorter adjacent side 1405 that is adjacent to the reinforced side 1403. However, embodiments of the present disclosure are not so limited. For example, the reinforcement element 2501 may extend continuously around the housing 100, as illustrated in Figure 15. In such embodiments, a portion of the reinforcement element 2501 extending along the adjacent side 1405 of the housing 100 may be against and attached to the adjacent side 1405 through welding, rivets, or any other suitable means. The portion of the reinforcement element extending along the adjacent side 1405 of the housing 100 may be longer than the adjacent side 1405 of the housing 100 to allow for a gap 2503 between the longer reinforced side 1403 of the housing 100 and the reinforcement element 2501.

As shown in Figure 25, the reinforcement element 2501 may snap into place on the housing 100 with a protrusion 2502 at the end of the reinforcement element 2501 and a corresponding opening on the housing 100. The shape of the opening may correspond to the shape of the protrusion 2502. For example, the reinforcement element 2501 may have a rectangular protrusion, and the opening of the housing 100 may also be rectangular.

The right side of Figure 25 depicts the reinforced side 1403 deformed through the gap 2503 to contact the reinforcement element 2501. An expansion force 2505 due to pressure and gases in the housing 100 are depicted in the illustration on the right. As described above, housing 100 may include a material and a design such that pressure formed during a short circuit event causes the reinforced side 1403 to expand past a desired point of expansion. The reinforced side 1403 of the housing 100 is under pressure to fill the gap 2503 between the reinforced side 1403 and the reinforcement element 2501. In some embodiments, the reinforcement element 2501 is configured such that, once the reinforced side 1403 has reached the desired point of expansion, the reinforced side 1403 rests against the reinforcement element 2501 at a desired point of expansion. In other embodiments, the reinforcement element 2501 is configured to deform a particular amount once the reinforced side 1403 contacts the reinforcement element 2501 such that the reinforced side 1403 expands to the desired point of expansion.

This description uses examples to disclose the invention and also to enable any person skilled in the art to practice the invention, including making and using any devices or systems and performing any incorporated methods. The patentable scope of the invention is defined by the claims and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A component comprising:
a housing for a circuit breaker, the housing comprising outer walls on at least four sides; and
a reinforcement element mounted on the housing along a reinforced side of the housing, the reinforced side comprising a side of the four sides, the reinforcement element formed separately than the housing,
wherein the reinforcement element is placed external to the reinforced side of the housing subject to deformation outward from an interior of the housing during a short circuit event.

2. The component of claim 1, at least one of:
wherein the housing comprises a top side that is open and a bottom side that is closed, wherein the reinforcement element is located on the reinforced side of the housing along a top portion adjacent to the top side of the housing; and
wherein the reinforcement element covers the reinforced side of the housing.

3. The component of claim 1 or 2, wherein the reinforcement element comprises a portion at each end of the reinforced side that wraps around and covers a portion of two sides adjacent to the reinforced side.

4. The component of one of claims 1 to 3, wherein the reinforcement element fits in a recess in the housing.

5. The component of claim 3, wherein the reinforcement element attaches to the housing on the two sides adjacent to the reinforced side.

6. The component of claim 4, wherein the reinforcement element and housing are configured so the reinforcement element snaps into place on the housing.

7. The component of claim 5, wherein the reinforcement element snaps into place on the housing with:
a protrusion at an end of the reinforcement element and a corresponding opening on the housing; and/or
a protrusion on the housing and a corresponding opening at the end of the reinforcement element.

8. The component of one of claims 1 to 7, at least one of:
wherein the reinforcement element connects to the housing via a weld, a connector, and/or an adhesive at least at each end of the reinforcement element;
wherein the housing comprises a material and a design such that pressure formed during a short circuit event causes the reinforced side to expand past a desired point of expansion and wherein the reinforcement element is positioned against the housing and comprises a material and a design to limit expansion of the reinforced side to the desired point of expansion;
wherein the housing comprises a material and a design such that pressure formed during a short circuit event causes the reinforced side to expand past a desired point of expansion and wherein the reinforcement element comprises a gap between the reinforced side and the reinforcement element and wherein during a short circuit event, the reinforced side expands to the reinforcement element and to the desired point of expansion;
wherein the reinforcement element comprises a plastic, fibers, and/or a tape; and
wherein the housing comprises two or more reinforced sides each with a reinforcement element.

9. A method comprising:
providing a housing for a circuit breaker, the housing comprising outer walls on at least four sides; and
connecting a reinforcement element to the housing along a reinforced side of the housing, the reinforced side comprising a side of the four sides, the reinforcement element formed separately than the housing,
wherein the reinforcement element is placed external to the reinforced side of the housing subject to deformation outward from an interior of the housing during a short circuit event.

10. The method of claim 9, wherein the housing comprises a top side that is open and a bottom side that is closed, wherein the reinforcement element is located on the reinforced side of the housing along a top portion adjacent to the top side of the housing and the reinforcement element fits in a recess in the housing.

11. The method of claim 9 or 10, wherein the reinforcement element comprises a portion at each end of the reinforced side that wraps around and covers a portion of two sides adjacent to the reinforced side and wherein the reinforcement element attaches to the housing on the two sides adjacent to the reinforced side.

12. The method of claim 11, wherein the reinforcement element and housing are configured so the reinforcement element snaps into place on the housing and wherein the reinforcement element snaps into place on the housing with:
a protrusion at an end of the reinforcement element and a corresponding opening on the housing; and/or
a protrusion on the housing and a corresponding opening at the end of the reinforcement element.

13. The method of one of claims 9 to 12, wherein the housing comprises a material and a design such that pressure formed during a short circuit event causes the reinforced side to expand past a desired point of expansion and wherein one of:
the reinforcement element is positioned against the housing and comprises a material and a design to limit expansion of the reinforced side to the desired point of expansion; and
the reinforcement element comprises a gap between the reinforced side and the reinforcement element and wherein during a short circuit event, the reinforced side expands to the reinforcement element and to the desired point of expansion.

14. A component comprising:
a housing for a circuit breaker, the housing comprising outer walls on at least four sides, a top side that is open, and a bottom side that is closed; and
a reinforcement element mounted on each of two reinforced sides, the reinforced sides comprising two of the four sides that are opposite each other, the reinforcement elements mounted along a top portion adjacent to the top side of the housing, the reinforcement elements formed separately than the housing,
wherein the reinforcement elements are placed external to the reinforced side of the housing subject to deformation outward from an interior of the housing during a short circuit event.

15. The component of claim 14, wherein the reinforcement element fits in a recess in the housing and wherein for each reinforcement element on a reinforced side, the reinforcement element comprises a portion at each end of the reinforced side that wraps around and covers a portion of two sides adjacent to the reinforced side and wherein the reinforcement element attaches to the housing on the two sides adjacent to the reinforced side and wherein the reinforcement element and housing are configured so the reinforcement element snaps into place on the housing and wherein the reinforcement element snaps into place on the housing with:
a protrusion at an end of the reinforcement element and a corresponding opening on the housing; and/or
a protrusion on the housing and a corresponding opening at the end of the reinforcement element.
